# EUROPEAN PATENT APPLICATION

(11) **EP 2 061 289 A1**
(43) Date of publication of application: **20.05.2009**
(21) Application number: 07301547.1
(22) Date of filing: 13.11.2007
(51) Int. Cl.: H05K 1/14

(54) **Interconnection of embedded passive components and substrates**

(71) Applicant: ST MICROELECTRONICS S.A., 92120 Montrouge (FR)
(72) Inventor: Vittu, Julien, 38250 Villard de Lans (FR)
(74) Representative: de Beaumont, Michel

(57) **Abstract**

The invention provides a multi-substrate electronic component, comprising two or more substrates (Sub1, Sub2) having one or more surface mount devices (S) positioned between the substrates. Each surface mount device is soldered to both the substrates, so that the substrates are held substantially parallel and together at a certain distance.

## Description

### FIELD OF THE INVENTION

The present invention concerns multi-level packages for electronic components, in particular semiconductor components. More specifically, it concerns the connections between multiple substrates in such components.

### BACKGROUND OF THE INVENTION

The markets for electronic equipment and the electronic components therein require that they be as small as possible, within the constraints imposed by the required function and the manufacturing technology employed. Therefore, in order to pack as much functionality into as small a volume as possible, 3D packages are often used for electronic components.

Many electronic components are themselves composed of supporting structures, called substrates, and a number of other electronic devices. These electronic devices can include integrated circuits (IC's), discrete semiconductors, and passive devices such as resistors, capacitors, inductors and filters. The substrates provide mechanical support for the devices inside and electrical connections between the various devices and between them and the external component connections.

Some electronic devices, which are designed to be soldered to the surface of a substrate, are known as surface-mount devices, or SMDs for short, and include, amongst other things, passive devices such as capacitors, inductors, resistors and filters, and discrete active devices, such as diodes. Such devices have a device body and one or more metallized areas, which serve as solder terminals, generally forming caps over the ends of the device. They are usually attached by being placed onto metallized areas, sometimes known as 'pads', on the substrate where an appropriate quantity of solder paste has been added. Heating is then used to melt the solder and cause it to wet the bottom and, generally, the sides of the device's solder terminal.

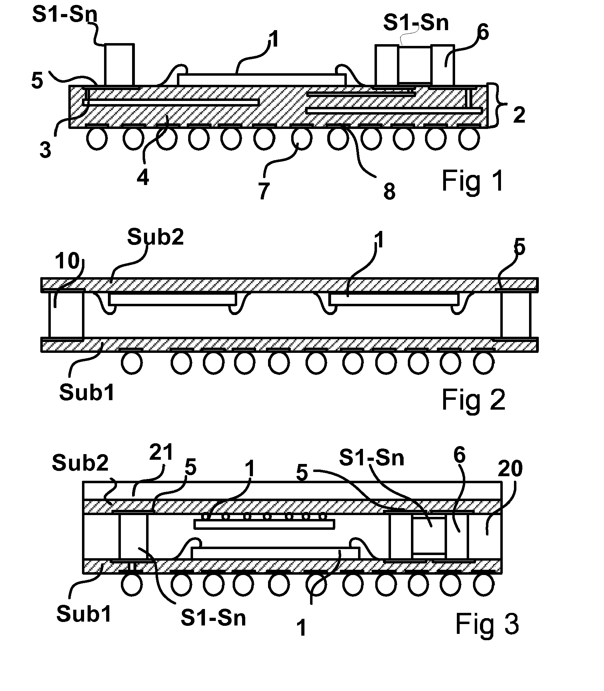

Fig 1 represents a cross-section of an exemplary electronic component employing a single substrate and is shown to illustrate basic concepts of assembly. A semiconductor die **1** is mounted on a substrate **2** which contains patterned metal layers **3** held in an insulating material **4.** Additionally, **SMD's S1-Sn** are soldered to appropriately positioned pads **5,** formed from the metal layers **3** on the substrate surface, using their solder terminals **6.** In this example, on one surface of the substrate are arranged solder balls **7,** attached to appropriately sized metallized pads **8,** which provide the means for external electrical connections.

In a multi-substrate package, it is often necessary to have electrical connections between the substrates. It is also necessary to provide some form of mechanical support that keeps the substrates apart, at least during the processing

Various means of providing these connections which involve reserving areas of the substrate for the vertical connections, such as metal or PCB spacers, are known, for instance in US patent 6583503.

Fig 2 represents a cross-section of a multi-substrate package as described in US patent 6583503. Substrates **Sub2, Sub1**, hereafter 'top' and 'bottom' substrates respectively, are placed one above the other. Top substrate **Sub2** has attached to it semiconductor dice **1.** Top and bottom substrates, **Sub2, Sub1** have been increased in size in order to receive metal posts **10** at their peripheral area. Posts **10** are attached, such as by soldering, to metal areas **5** on each substrate. The metal posts **10** connect electrically and mechanically the top and bottom substrates **Sub2, Sub1.**

The structures for connecting the substrates discussed above occupy significant substrate surface area and must be taller than the tallest device on the substrates, thus increasing the overall volume of the component beyond that needed for the actual devices therein. Additionally, extra processing steps are required to implement them. There is, therefore, a need to improve the techniques of connecting, electrically and mechanically, substrates placed one above another.

### SUMMARY OF THE INVENTION

Depending on the implementation, some or all of the concerns discussed above are addressed by an electronic component which comprises;
a first substrate;
a second substrate; and
at least one surface mount device soldered to said first and second substrates, such that said first and second substrates are held apart and substantially parallel to each other.

According to an embodiment of the invention, an electronic wherein the space defined between the substrates is at least partially filled with electrically insulating material.

According to an embodiment of the invention, is provided an electronic which comprises, within the space defined between the first and second substrates, at least one semiconductor die connected to one of the substrates.

According to an embodiment of the invention, is provided an electronic component which comprises, within the space defined between the first and second substrates, at least one semiconductor die connected to one of the substrates and at least one other semiconductor die connected to another of the substrates.

According to an embodiment of the invention, is provided an electronic component wherein a surface mount device forms an element in an electrical circuit between the first and second substrates.

According to an embodiment of the invention, is provided an electronic component which comprises:
a plurality of surface mount devices soldered to the first and second substrates, and arranged around an area; and
a metal layer or mesh in at least one of the first and second substrates, connected to the surface mount devices, and extending substantially over the area.

According to an embodiment of the invention, is provided an electronic component, wherein the exterior surface of the component is at least partially covered in an insulating material.

Is provided, a portable electronic equipment which comprises an electronic component according to an embodiment of the invention.

Is provided, a method of connecting at least two substrates which comprises the steps of soldering a surface mount device to a first of the substrates and soldering a second substrate to the surface mount device, such that the first and second substrates are held apart and substantially parallel to each other.

According to an embodiment of the invention, is provided a method of connecting a plurality of substrates which comprises the steps of:
presenting the substrates in first and second arrays that are provided with alignment holes;
connecting semiconductor dice to said substrates;
placing the first array over pins going through the holes of the first array; and
aligning a second array with the first array by means of the pins going through the holes of the second array.

### BRIEF DESCRIPTION OF THE DRAWINGS

The foregoing and other purposes, features, aspects and advantages of the invention will become apparent from the following detailed description of embodiments, given by way of illustration and not limitation with reference to the accompanying drawings.
Fig 1 represents a cross-section view of an example of an electrical component comprising an assembly of a number of electrical devices arranged on a single substrate.
Fig 2 represents a cross-section view of an electrical component with superposed substrates, illustrating a known technique of assembling the substrates.
Fig 3 represents a cross-section of an electronic component according to an embodiment of the present invention.
Fig 4 represents a detailed cross-section view of an embodiment of the invention, showing alternative signal paths between substrates.
Fig 5 represents a cross-section of an electronic component having electromagnetic shielding according to an embodiment of the invention.
Fig 6 illustrates a method of aligning two or more substrates for the purposes of making connections between them according to an embodiment of the invention.
Fig 7 shows a mobile equipment including an electronic component according to an embodiment of the invention.

### DETAILED DESCRIPTION OF THE INVENTION

Certain elements of the structures described below have already been shown and will not be discussed further. Furthermore, throughout this description, same references designate same elements.

Fig 3 represents a cross-section view of an electronic component incorporating an embodiment of the invention. A plurality of semiconductor dice **1** are each attached to a face of bottom and top substrates **Sub1, Sub2.** Electrical connections between each semiconductor die and its respective substrate are in this example made by wire-bonding. SMDs **S1-Sn** are placed between the substrates **2** in order that their solder terminals **6** can be soldered to appropriately placed pads **5** on both the top and the bottom substrates. By virtue of being soldered to the top and bottom substrates, SMDs **S1-Sn** hold together the substrates at a distance from each other and achieve electrical connections between the substrates via the solder terminals **6** of the SMDs.

The SMDs may be of different sizes and functions and may be arranged in different orientations (as represented in Figs 1 et al). The size and orientation of the SMDs used for connecting the top and bottom substrates is chosen so that those SMDs are of the same mounted height within the tolerances required by the soldering process being used to connect the second substrate. "Mounted height" is the dimension perpendicular to the substrate on which the SMD is mounted from the substrate surface to the top of the SMD.

Thus soldering at least three SMDs of equal mounted height will ensure a stable positioning of the substrates, substantially parallel to each other. Fewer than three SMDs can be used, provided the substrates are held at the desired alignment during the soldering procedure.

As is obvious to one of ordinary skill, SMDs of lower height may be used for devices which are not required for connecting the top and bottom substrates.

The cavity so formed between the substrates may be filled, wholly or partially, with an appropriate, electrically insulating, material **20** such as polymer resin. SMDs **S1-Sn** also hold the substrates at a fixed distance during the processes of filling the cavity and polymerizing the resin. It is also possible to cover the exterior, either wholly or partially in a suitable insulating material **21** such as a polymer resin and this may be advantageous in certain circumstances. This external covering is shown only on the top surface, though it may also extend over other surfaces, according to the details of the manufacturing process used.

Electrical connections between the top and bottom substrates that are obtained by using SMDs do not occupy any more surface area of substrate than is occupied by the surface mount devices themselves. Therefore there are no specific areas of substrate dedicated purely to the connections between substrates nor is the substrate area increased to provide for connections. Also, the distance between the substrates is no more than the height of the SMDs. Thus the overall volume needed for the electronic device is reduced relative to that which would be obtained with conventional methods of making multi-substrate components.

Furthermore, the extra process steps for a two substrate component, according to the invention, beyond those needed to manufacture a single substrate component, involve only the positioning of a second substrate above a first substrate and the soldering of the second substrate to the SMDs mounted on the first substrate. The processing necessary for mounting the SMDs on the first substrate is the normal processing needed for a single substrate component. The processing needed for the prior art previously cited requires dedicated steps for attaching the metal posts both for the first and for the subsequent substrates. These processing steps are also in addition to any mounting of SMDs. However, in the case of the present invention, some of the processing needed for forming connections between substrates has been included in the processing necessary for mounting the SMDs on the first substrate. Therefore this represents a saving in the processing steps compared to those necessary for adding connections using conventional means.

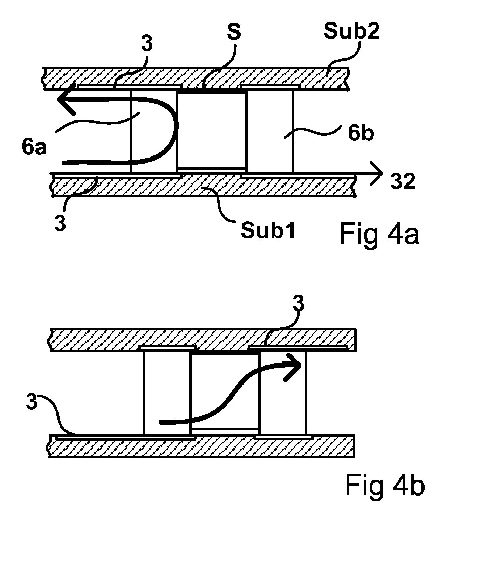

Figs 4a and 4b show alternatives for obtaining paths for signals between the substrates via SMDs.

In Fig 4a, an SMD **S** is, as explained with relation to Fig 3, soldered to each substrate **Sub1, Sub2.** Metal patterns **3** on the substrates are arranged so that a signal passes directly from one substrate to the other via a first solder terminal 6a of the SMD **S.** Another solder terminal 6b of the SMD may be connected, using an appropriately placed metal pattern on one or both substrates **Sub1, Sub2,** to another branch of an electrical circuit **32.** Thus the SMD **S** may be said to be a parallel element with respect to the signal path passing from one substrate to the other.

In Fig 4b metal patterns **3** on the substrates are arranged so that the signal passes from one substrate to the other through the SMD **S** itself, i.e. the SMD **S** forms a series element in signal path from one substrate to the other.

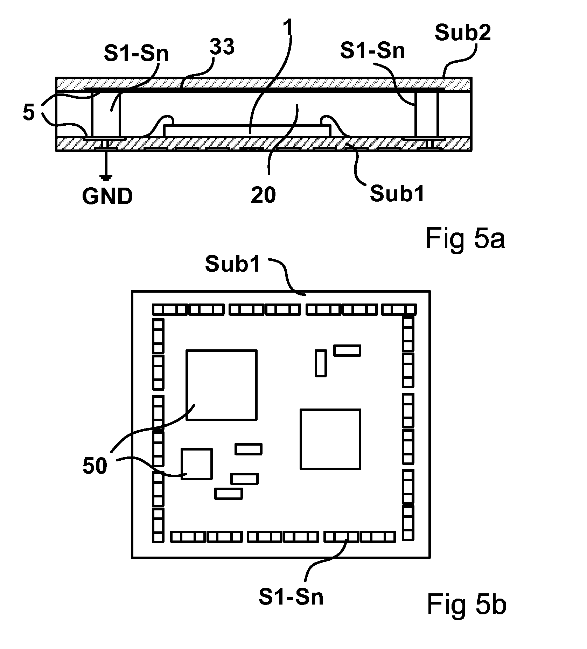

Fig 5a represents a cross-section view of an electronic component where electromagnetic shielding of elements mounted within the electrical component is obtained through a specific arrangement of SMDs and metal patterns according to an embodiment of the invention.

A semiconductor die **1,** is placed between top and bottom substrates **Sub2, Sub1** and is attached to a face of one of the substrates. The substrates are connected to each other by SMDs **S1-Sn,** these being soldered to appropriately placed pads **5** on the respective substrates **Sub1, Sub2** as explained with relation to Fig 4a or 4b. One of the substrates, in this case bottom substrate **Sub1,** has connections from one or more of the pads **5** to an electrical ground, **GND.** A metal pattern **33,** made in the same way as the other metal patterns here discussed, is arranged on the inner face of the top substrate so that it extends over the area defined between SMDs **S1-Sn.** The pattern **33** is coupled through selected pads **5** of the top substrate **Sub2 ,** corresponding to solder terminals **6** of SMDs **S1-Sn** and the corresponding pads **5** of bottom substrate **Sub1** that are connected to the electrical ground **GND.**

As before, the cavity between the substrates maybe filled with appropriate materials **20**

Fig 5b represents a plan-view of the electronic component of Fig 5a. SMDs **S1-Sn** are arranged to form an enclosure around a variety of electronic devices **50.** The solder terminals **6** connecting the metal pattern **33** to electrical ground **GND** form a lateral electromagnetic shield. The maximum spacing of the SMDs **S1-Sn** selected to form part of an electromagnetic shield depends on the electromagnetic shielding properties desired at the frequencies of interest. It may be not necessary that all SMDs present form part of the enclosure, and therefore, according to the circuits required, these may or may not be connected to the electrical ground **GND.**

A person of ordinary skill will be able to determine this and be able to design the metal pattern **33** in terms of its shape, the presence or not of un-metallized areas and the size, number and placement of any such areas in order to obtain desired electromagnetic shielding properties.

A person of ordinary skill will see that the metal pattern **33** could also be formed in a metal layer embedded inside the substrate or on the outer face of the substrate, and connected to the pads **5** through vias.

It can be appreciated easily by a person of ordinary skill that electromagnetic shielding could also be beneficial to electrical devices incorporating elements other than semiconductor dice and that these can be placed with equal ease inside the volume protected by the electromagnetic shielding

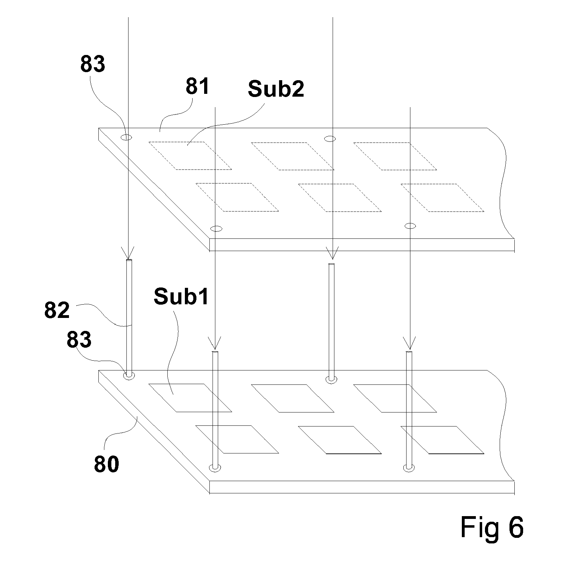

Fig 6 shows a method of superposing and aligning two or more substrates to form electrical components according to embodiments of the invention. The top and bottom substrates **Sub2, Sub1** are present in the form of arrays, hereafter called bottom 'strip' and top 'strip' **80, 81.** Firstly, both strips receive a share of the various ICs, SMDs and other devices needed for the function, the sharing being a matter of convenience according to the equipment and processing being used. A strip or substrate with its electronic devices attached is referred to as 'populated'.

Populated bottom strip **80** is placed in a workholder (not shown) which has locating pins **82** placed such that they pass perpendicularly through holes **83** made for this purpose. Populated top strip, after whatever preprocessing is needed, for example solder paste application, is then placed so that the locating pins pass through holes **83** in the same manner as for the bottom strip. The positioning of the substrates in the strips is calculated carefully so that the top and bottom substrates **Sub2, Sub1** are aligned correctly when the strips are aligned by the locating pins **82.** Populated top strip **81** is then moved into contact with the SMDs on bottom strip and the soldering process performed.

According to the machines for populating the substrates, there may be many variations on the precise order of placing of components on a strip and its insertion into the workholder. Also, the locating pins may be separate from the workholder, being inserted after placement of one or more of the strips.

The subsequent steps of separation into individual substrates, filling of the cavity, encapsulation, and attachment of any exterior connections, such as solder-balls, are then performed, according to a standard packaging flow using machines adapted for the thickness of the package in question. One of ordinary skill will be able to determine the most convenient order for these steps.

As one of ordinary skill may appreciate, a component manufactured according to the invention will, by virtue of its small volume, be very attractive for use in equipment where space must be saved. In handheld and other portable equipment, such as mobile communications devices, space is particularly at a premium.

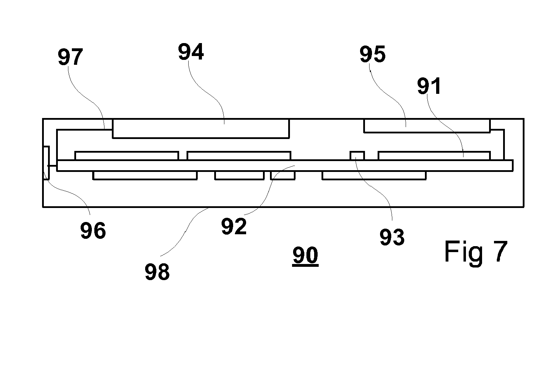

Fig 7 shows a simplified representation of a mobile equipment **90,** such as, amongst other things, mobile phones, TVs, radios and music players. An electronic component according to the invention **91** is attached to a printed circuit board **92** which has also attached other components **93.** Also present are a device **94,** such as a keypad, for receiving input from the user, a device **95** for displaying information to the user and a device **96** for electrical connections to other equipment, all these being attached by various means **97** to the printed circuit board **92.** The equipment is housed in a protective cover **98,** made of a suitable material.

The detailed description set forth above, with the appended drawings, is intended to provide a description of the preferred embodiments and features, and is not intended to represent the only form nor imply any preferred combination of the features. It is to be understood that the same function may be accomplished by different embodiments which are intended to be encompassed within the scope of the present invention.

For instance, various structures for the external electrical connections are possible, such as metal pads for soldering or metal pins. For simplicity these were not discussed here because the choice of these is not directly linked to the implementation of the invention. Also, though this is not shown here for reasons of clarity, in many, but not all cases, the whole electronic component may be encapsulated in a suitable material. Examples of such materials include metal housings and polymer resins. Furthermore, the semiconductor dice may be attached and connected electrically to the substrates by different methods - the techniques of wire-bond and solder bumping have been illustrated herewith.

The above examples show multilayer substrates, though one ordinary skill will appreciate that other forms of substrate are possible, such as patterned metal plates and structures based on flexible polymer tapes.

The above examples show two substrates though the stacking of more than two substrates is possible.

Having thus described at least one illustrative embodiment of the invention, various alterations, modifications and improvements will readily occur to those skilled in the art. Such alterations, modifications and improvements are intended to be within the spirit and scope of the invention. Accordingly, the foregoing description is by way of example only and is not intended to be limiting. The invention is limited only as defined in the following claims and the equivalent thereto.

## Claims

1. An electronic component comprising;
a first substrate (Sub1);
a second substrate (Sub2);
**characterized in that** it comprises at least one surface mount device (S) soldered to said first and second substrates, such that said first and second substrates are held apart and substantially parallel to each other.

2. An electronic component according to claim 1, wherein the space defined between said substrates is at least partially filled with electrically insulating material (20).

3. An electronic component according to claim 1 or 2, comprising, within the space defined between the first and second substrates, at least one semiconductor die (1) connected to one of said substrates.

4. An electronic component according to claim 3, comprising, within the space defined between the first and second substrates, at least one other semiconductor die (1) connected to another of said substrates.

5. An electronic component according to claim 1, wherein a surface mount device (S) forms an element in an electrical circuit between said first and second substrates (Sub1, Sub2).

6. An electronic component according to claim 1, comprising:
a plurality of surface mount devices (S1-Sn) soldered to said first and second substrates, and arranged around an area; and
a metal layer or mesh (33) in at least one of said first and second substrates, connected to said surface mount devices, and extending substantially over said area.

7. An electronic component according one of claims 1 to 6, wherein the exterior surface of the component is at least partially covered in an insulating material (21).

8. A portable electronic equipment comprising an electronic component according to claim 1.

9. A method of connecting at least two substrates, comprising the step of soldering a surface mount device to a first of said substrates,
**characterized in that** it comprises the step of soldering the second of said substrates (Sub2) to said surface mount device S, such that the first and second substrates are held apart and substantially parallel to each other

10. A method of connecting a plurality of substrates according to claim 7, comprising the steps of:
presenting the substrates (Sub1, Sub2) in first and second arrays (80, 81) provided with alignment holes (83);
connecting semiconductor dice to said substrates;
placing the first array (80) over pins (82) going through said holes (82) of the first array; and
aligning said second array (81) with said first array by means of said pins (82) going through said holes (82) of said second array (81).
